# FASCICULE DE BREVET EUROPEEN

(11) **EP 3 646 374 B1**
(45) Date de publication et mention de la délivrance du brevet: **19.05.2021**
(21) Numéro de dépôt: 18732347.2
(22) Date de dépôt: 21.06.2018
(51) Int. Cl.: H01L 21/762, H01L 41/312

(54) **PROCÉDÉ DE TRANSFERT D'UNE COUCHE MINCE SUR UN SUBSTRAT SUPPORT PRÉSENTANT DES COEFFICIENTS DE DILATATION THERMIQUE DIFFÉRENTS**
VERFAHREN ZUR ÜBERTRAGUNG EINER DÜNNEN SCHICHT AUF EIN TRÄGERSUBSTRAT MIT UNTERSCHIEDLICHEN WÄRMEAUSDEHNUNGSKOEFFIZIENTEN
PROCESS FOR TRANSFERRING A THIN LAYER TO A SUPPORT SUBSTRATE THAT HAVE DIFFERENT THERMAL EXPANSION COEFFICIENTS

(30) Priorité: 30.06.2017 FR 1756116
(43) Date de publication de la demande: 06.05.2020
(73) Titulaire: Soitec, 38190 Bernin (FR)
(72) Inventeur: HUYET, Isabelle, 38920 Crolles (FR); CHARLES-ALFRED, Cédric, 38000 Grenoble (FR); LANDRU, Didier, 38190 Le Champs-près-Froges (FR); DROUIN, Alexis, 38530 La Buissière (FR)
(74) Mandataire: IP Trust
(86) Numéro de dépôt international: PCT/EP2018/066552
(87) Numéro de publication internationale: WO 2019/002080

(56) Documents cités:
- FR-A1- 2 914 492
- FR-A1- 3 007 892
- US-A1- 2003 186 521
- US-B1- 6 593 212

## Description

### DOMAINE DE L'INVENTION

La présente invention concerne le domaine des structures hétérogènes, associant deux substrats présentant des coefficients de dilatation thermique différents. Plus particulièrement, l'invention porte sur un procédé de transfert d'une couche mince sur un substrat support. Ce procédé de fabrication est utilisé, par exemple, dans les domaines de la microélectronique, de la micromécanique, de la photonique...

### ARRIERE PLAN TECHNOLOGIQUE DE L'INVENTION

On connaît de l'état de la technique différents procédés permettant de former une couche mince sur un substrat support. Il peut s'agir, par exemple, d'une technique d'épitaxie par jet moléculaire (« Molecular Beam Epitaxy » en anglais), de pulvérisation plasma (« Plasma Sputtering » en anglais), dépôt par plasma (« Laser Pulsed Déposition » en anglais), ou encore de l'application de la technologie Smart Cut™ selon laquelle une couche mince est prélevée d'un substrat massif par fracture au niveau d'une zone fragile (ou plan de fragilisation) formée dans le substrat massif par implantation d'espèces légères.

La présente invention concerne plus particulièrement la formation d'une couche mince en matériau ferroélectrique obtenue par l'application d'un tel procédé, comme cela est enseigné dans le document FR 2 914 492.

Les documents FR 3 007 892 A1, US 6 593 212 B1 et US 2003/186521 décrivent des procédés de transfert d'un film mince d'un premier substrat ayant un premier coefficient de dilatation thermique vers un deuxième substrat ayant un deuxième coefficient de dilatation thermique différent du premier coefficient de dilatation thermique.

L'application du procédé Smart Cut est bien adaptée dans le cas où le matériau de la couche mince que l'on veut transférer présente un coefficient de dilatation thermique similaire à celui du substrat support sur lequel le transfert à lieu.

Dans le cas contraire, la température à laquelle peut être soumis l'assemblage formé du substrat support et du substrat donneur est limitée. Ainsi, le document FR2856192 rappel qu'un traitement thermique supérieure à une température déterminée par la valeur des coefficients de dilatation thermique des matériaux, peut entrainer la fracture incontrôlée de l'un des substrats et/ou la délamination du substrat donneur ou de la couche mince. Cela pose problème car le procédé Smart Cut peut nécessiter d'effectuer au moins un traitement thermique à une température suffisante afin, par exemple, de renforcer l'adhésion du substrat donneur au substrat support, ou de faciliter la fracture du substrat donneur au niveau du plan de fragilisation.

### OBJET DE L'INVENTION

Un but de l'invention est de proposer un procédé de transfert d'une couche mince constituée d'un premier matériau sur un substrat support constitué d'un deuxième matériau, le premier et le deuxième matériau présentant des coefficients de dilatation thermique différents, adressant en partie au moins le problème précité. Elle trouve notamment son application pour le transfert d'une couche mince en matériau ferroélectrique sur un support présentant un coefficient de dilatation différent du matériau composant cette couche mince, par exemple un substrat support en silicium.

### BREVE DESCRIPTION DE L'INVENTION

En vue de la réalisation de l'un de ces buts, l'objet de l'invention propose un procédé de transfert d'une couche mince constituée d'un premier matériau sur un substrat support constitué d'un deuxième matériau, le premier et le deuxième matériau présentant des coefficients de dilatation thermique différents. Selon l'invention, le procédé de transfert d'une couche mince constituée d'un premier matériau sur un substrat support constitué d'un deuxième matériau, le premier et le deuxième matériau présentant des coefficients de dilatation thermique différents, le procédé étant caractérisé en ce qu'il comporte :a. la fourniture d'un substrat donneur obtenu par collage d'une couche épaisse formée du premier matériau (la) et d'un substrat manipulateur (1b), la différence de coefficient de dilatation thermique du matériau constituant le substrat manipulateur (1b) et de celui du substrat support étant moindre, en valeur absolue, que la différence de dilatation thermique de la couche épaisse (la) et de celui du substrat support, et le substrat donneur présentant une face principale du côté de la couche épaisse (la) ;b. l'introduction d'espèces légères dans la couche épaisse (la) pour y générer un plan de fragilisation et définir la couche mince entre le plan de fragilisation et la face principale du substrat donneur;c. l'assemblage de la face principale du substrat donneur avec une face du substrat support ;d. le détachement de la couche mince au niveau du plan de fragilisation, le détachement comprenant l'application d'un traitement thermique.

L'assemblage formé du substrat donneur et du support peut être exposé à une température bien plus élevée que celle appliquée dans le cadre d'une approche « directe » conforme à l'état de la technique selon laquelle le substrat donneur ne comporte pas de substrat manipulateur, sans risque de fracture incontrôlée de l'un des substrats ou de délamination du substrat donneur ou de la couche mince. La structure équilibrée, en termes de coefficient de dilatation thermique de cet assemblage, permet notamment de faciliter l'étape de détachement de la couche mince en exposant l'assemblage à une température relativement élevée.

Selon d'autres caractéristiques avantageuses et non limitatives de l'invention, prises seules ou selon toute combinaison techniquement réalisable :
- le coefficient de dilatation thermique du premier matériau constituant la couche épaisse et celui du deuxième matériau constituant le substrat support sont différent d'au moins 10% à température ambiante ;
- les espèces légères implantées sont des ions d'hydrogène et/ou d'hélium ;
- le premier matériau est un matériau ferroélectrique tel que du LiTaO3, LiNbO3, LiAlO3, BaTiO3, PbZrTiO3, KNbO3, BaZrO3, CaTiO3, PbTiO3 ou du KTaO3 ;
- le matériau du substrat support est du silicium ;
- le substrat manipulateur est de même nature que le substrat support ;
- le substrat manipulateur possède une épaisseur équivalente à celle du substrat support ;
- la couche épaisse présente une épaisseur comprise entre 10 et 400 micromètres pour permettre le prélèvement d'une ou plusieurs couches minces ;
- le collage est obtenu par adhésion moléculaire ;
- une étape d'amincissement du substrat source est comprise pour fournir la couche épaisse ;
- l'étape d'amincissement est réalisée par meulage et/ou polissage mécano-chimique et/ou gravure.

### BREVE DESCRIPTION DES DESSINS

D'autres caractéristiques et avantages de l'invention ressortiront de la description détaillée de l'invention qui va suivre en référence aux figures annexées sur lesquelles :
- les figures 1A à 1D présentent un mode de réalisation d'un procédé conforme à l'invention ;
- la figure 2 représente schématiquement un procédé de formation d'un substrat donneur conforme à l'invention.

### DESCRIPTION DETAILLEE DE L'INVENTION

Par souci de simplification de la description à venir, les mêmes références sont utilisées pour des éléments identiques ou assurant la même fonction dans l'état de la technique ou dans les différents modes de mise en œuvre exposés du procédé

Les figures sont des représentations schématiques qui, dans un objectif de lisibilité, ne sont pas à l'échelle. En particulier, les épaisseurs des couches ne sont pas à l'échelle par rapport aux dimensions latérales de ces couches.

L'expression « coefficient de dilatation thermique » employée dans la suite de cette description en relation à une couche ou à un substrat fait référence au coefficient de dilatation selon une direction définie dans le plan principal définissant cette couche ou ce substrat. Si le matériau est anisotrope, la valeur du coefficient retenu sera celle de plus grande amplitude. La valeur du coefficient est celle mesurée à température ambiante.

L'invention concerne un procédé de transfert d'une couche mince 3 constituée d'un premier matériau sur un substrat support 7 constitué d'un deuxième matériau, le premier et le deuxième matériau présentant des coefficients de dilatation thermique différents. Par « différent », on signifie que ces coefficients diffèrent d'au moins 10%.

Dans le cadre de cette description, on considéra, à titre d'exemple, que la couche mince 3 est en matériau ferroélectrique et le support 7 en silicium (dont le coefficient de dilatation thermique est estimé à 2.6 x10⁻⁶ K⁻¹) .

On rappelle qu'un matériau ferroélectrique est un matériau qui possède une polarisation électrique à l'état naturel, polarisation qui peut être renversée par l'application d'un champ électrique extérieur. On appelle domaine ferroélectrique, chaque région d'un seul tenant du matériau dans lequel la polarisation est uniforme (tous les moments dipolaires sont alignés parallèlement les uns aux autres suivant une direction donnée). Un matériau ferroélectrique peut donc être caractérisé de « monodomaine » dans le cas où ce matériau est constitué d'une seule région dans laquelle la polarisation est uniforme ou de « multidomaine » dans le cas où le matériau ferroélectrique comprend une pluralité de région présentant des polarités pouvant être différentes.

D'une manière générale, il est généralement souhaitable de disposer d'une couche mince ferroélectrique présentant un caractère monodomaine.

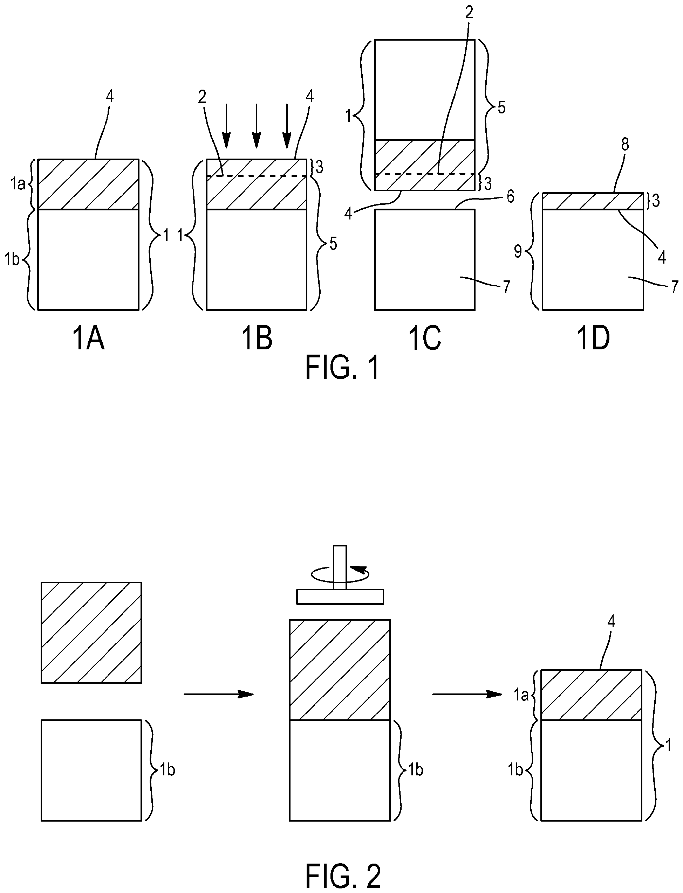

En référence à la figure 1A, le substrat donneur 1 est composé d'une couche épaisse de matériau ferroélectrique la, par exemple de LiTaO3 (2x10⁻⁶ K⁻¹ (z), 16x10⁻⁶ K⁻¹ (x, y)), LiNbO3, LiAlO3, BaTiO3, PbZrTiO3, KNbO3,BaZrO3, CaTiO3, PbTiO3 ou de KTaO3 et d'un substrat manipulateur 1b. Le substrat donneur 1 peut prendre la forme d'une plaquette, circulaire, de dimension normalisée, par exemple de 150 mm ou 200 mm de diamètre. Mais l'invention n'est nullement limitée à ces dimensions ou à cette forme. La couche épaisse de matériau la peut avoir été prélevé d'un lingot de matériaux ferroélectrique, ce prélèvement ayant été réalisé de manière à ce que la couche épaisse la présente une orientation cristalline prédéterminée. L'orientation est choisie en fonction de l'application visée. Ainsi, il est usuel de choisir une orientation 42°RY dans le cas où l'on souhaite exploiter les propriétés de la couche mince pour former un filtre SAW. Mais l'invention n'est nullement limitée à une orientation cristalline particulière.

Le substrat manipulateur 1b est avantageusement constitué d'un matériau (ou d'une pluralité de matériaux) lui conférant un coefficient de dilatation thermique proche de celui composant le substrat support 7. Par « proche », on signifie que la différence de coefficient de dilatation thermique du substrat manipulateur 1b et de celui du support 7 est moindre, en valeur absolue, que la différence de dilatation thermique de la couche épaisse la et de celui du substrat support 7.

Préférentiellement, le substrat manipulateur 1b et le substrat support présentent un coefficient de dilatation thermique identique. Lors de l'assemblage du substrat donneur et du support, on forme une structure apte à supporter un traitement thermique à une température relativement élevée. Pour des raisons de simplicité de mise en œuvre, cela peut être obtenu en choisissant le substrat manipulateur 1b pour qu'il soit constitué du même matériau que celui du substrat support 7.

Pour former le substrat donneur 1, on assemble préalablement un bloc massif de matériau ferroélectrique avec le substrat manipulateur 1b, par exemple selon une technique de collage par adhésion moléculaire. Puis, on forme la couche de matériau ferroélectrique la par amincissement, par exemple par meulage et/ou polissage mécano-chimique et/ou gravure. Ce procédé est schématisé sur la figure 2. Avant l'assemblage on peut avoir prévu la formation d'une couche d'adhésion (par exemple par dépôt d'oxyde de silicium et/ou de nitrure de silicium) sur l'une et/ou l'autres des faces mises en contact. L'assemblage peut comprendre l'application d'un traitement thermique de faible température (compris par exemple entre 50 et 300°C, typiquement 100°C) permettant de renforcer suffisamment l'énergie de collage pour permettre l'étape suivante d'amincissement.

Le substrat manipulateur 1b peut être choisi pour présenter une épaisseur sensiblement équivalente à celle du substrat support 7. L'étape d'amincissement est conduite de telle sorte que la couche épaisse la présente une épaisseur suffisamment faible pour que les contraintes générées lors des traitements thermiques appliqués dans la suite du procédé soient d'intensité réduite. Dans le même temps, cette épaisseur est suffisamment importante pour pouvoir y prélever la couche mince 3, ou une pluralité de telles couches. Cette épaisseur peut par exemple être comprise entre 5 et 400 microns.

Le procédé comprend l'introduction dans le substrat donneur 1 d'au moins une espèce légère. Cette introduction peut correspondre à une implantation, c'est à dire à un bombardement ionique de la face principale 4 du substrat donneur 1 par des espèces légères telles que des ions d'hydrogène et/ou hélium.

De façon connue en soi, et comme cela est représenté sur la figure 1B, les ions implantés ont pour but de former un plan de fragilisation 2 délimitant une couche mince 3 de matériau ferroélectrique à transférer qui est située du côté de la face principale 4 et une autre partie 5 constituant le reste du substrat.

La nature, la dose des espèces implantées et l'énergie d'implantation sont choisies en fonction de l'épaisseur de la couche que l'on souhaite transférer et des propriétés physico-chimiques du substrat donneur. Dans le cas d'un substrat donneur 1 en LiTaO3, on pourra ainsi choisir d'implanter une dose d'hydrogène comprise entre 1^{E}16 et 5^{E}17 at/cm² avec une énergie comprise entre 30 et 300keV pour délimiter une couche mince 3 de l'ordre de 200 à 2000 nm.

Dans une étape suivante, représentée sur la figure 1C, on assemble la face principale 4 du substrat donneur 1 avec une face 6 d'un substrat support 7. Le substrat support 7 peut présenter la même dimension et la même forme que celles du substrat donneur. Pour des raisons de disponibilité et de coût, le substrat support 7 est une plaquette de silicium, monocristallin ou polycristallin. Mais plus généralement, le substrat support 7 peut être constitué de tout matériau, par exemple du silicium, du saphir ou du verre, et présenter toute forme.

Préalablement à cette étape, il peut être envisagé de préparer les faces des substrats à assembler par une étape de nettoyage, brossage, séchage, polissage, ou une activation plasma.

L'étape d'assemblage peut correspondre à la mise en contact intime du substrat donneur 1 avec le substrat support 7 par adhésion moléculaire et/ou collage électrostatique. Optionnellement, pour faciliter l'assemblage des deux substrats 1, 7 notamment lorsqu'ils sont assemblés par collage direct, au moins une couche intermédiaire peut être formée préalablement à l'assemblage, soit sur la face principale 4 du substrat donneur 1, soit sur la face plane 6 à assembler du substrat support 7, soit sur les deux. Cette couche intermédiaire est par exemple constituée d'oxyde de silicium, de nitrure de silicium ou encore de silicium poly-crystallin et avoir une épaisseur comprise entre quelques nanomètres et quelques microns. La couche intermédiaire peut être élaborée selon les différentes techniques connues de l'état de l'art, telles des traitements thermiques d'oxydation ou de nitruration, des dépôts chimiques (PECVD, LPCVD...), etc.

A l'issue de cette étape d'assemblage, on dispose de l'ensemble représenté sur la figure 1C comprenant les deux substrats associés, la face plane 6 du substrat support 7 adhérant à la face principale 4 du substrat donneur 1.

L'ensemble est alors traité pour détacher la couche mince 3 de matériau ferroélectrique du substrat donneur 1, par exemple par clivage au niveau du plan de fragilisation 2.

Cette étape de détachement peut ainsi comprendre l'application à l'ensemble d'un traitement thermique dans une gamme de température de l'ordre de 80°C à 500° pour permettre le transfert de la couche mince 3 sur le substrat support 7. En complément du traitement thermique, cette étape peut comprendre l'application d'une lame ou un jet de fluide gazeux ou liquide au niveau du plan de fragilisation 2. Dans le cas d'un matériau ferroélectrique, on veillera à ne pas excéder sa température de Curie, de manière à ne pas détériorer les caractéristiques de la couche mince.

Suite à cette étape de détachement, on obtient la structure 9 représentée à la figure 1D. Cette structure 9 comprend la couche mince 3 de matériau ferroélectrique comprenant une première face libre 8 et sa face principale 4 disposée sur le substrat support 7.

L'assemblage formé du substrat donneur 1 et du support 7 peut être exposé à une température bien plus élevée que celle appliquée dans le cadre d'une approche « directe » conforme à l'état de la technique selon laquelle le substrat donneur ne comporte pas de substrat manipulateur, sans risque de fracture incontrôlée de l'un des substrats ou de délamination du substrat donneur 1 ou de la couche mince 3. La structure équilibrée, en termes de coefficient de dilatation thermique de cet assemblage, permet ainsi de faciliter l'étape de détachement de la couche mince 3en exposant l'assemblage à une température relativement élevée, par exemple comprise entre 80°C et 500°C.

Il est ensuite possible de procéder à une étape de finition de la couche mince 3 et notamment de sa face libre 8 afin de restaurer et/ou d'améliorer les propriétés souhaitées de cette couche mince. Comme cela est bien connu en soi, cette finition peut comprendre un polissage, une gravure, une oxydation sacrificielle, un recuit sous atmosphère neutre ou réductrice ou oxydante.

Dans le cadre de l'exemple qui vient d'être présenté, et dans lequel la couche mince 3 est en matériau ferroélectrique cette étape de finition peut correspondre à un traitement thermique de la couche mince 3 suivi d'un polissage, cette séquence permettant de restaurer la propriétés monodomaine initiale que possédait la couche épaisse la, par exemple suivant une orientation de 42°RY, au niveau de la couche mince 3 après transfert. Mais l'invention n'est nullement limitée à une séquence de finition particulière.

Le traitement thermique permet de guérir des défauts cristallins présents dans la couche mince 3. En outre, il contribue à consolider le collage entre la couche mince 3 et le support 7. Le traitement thermique porte la structure à une température comprise entre 300°C et la température de Curie du matériau ferroélectrique pendant une durée comprise entre 10 secondes et 10h heures. Ce traitement thermique est préférentiellement réalisé en exposant la face libre de la couche mince 3 à une atmosphère gazeuse oxydante ou neutre.

Le procédé de préparation comporte également, après le traitement thermique, un amincissement de la couche mince 3. Cet amincissement peut correspondre au polissage de la première face libre 8 de la couche mince 3, par exemple par des techniques d'amincissement mécanique, mécano-chimique et/ou de gravure chimique. Il permet de préparer la face libre 8 pour qu'elle présente une rugosité faible, par exemple inférieure à 0,5nm RMS 5x5 µm par mesure par force atomique (AFM) et d'enlever une partie superficielle de la première face libre 8 de la couche mince 3 susceptible de contenir des défauts résiduels.

Bien entendu l'invention n'est pas limitée à l'exemple décrit et on peut y apporter des variantes de réalisation sans sortir du cadre de l'invention tel que défini par les revendications.

De plus l'invention s'applique à toute structure « hétérogène » dans laquelle des différences de coefficient de dilatation thermique existent entre la couche mince 3 et le substrat support 7, tel que par exemple dans le cas d'une structure de silicium sur quartz ou de silicium sur saphir.

## Revendications

1. Procédé de transfert d'une couche mince (3) constituée d'un premier matériau sur un substrat support (7) constitué d'un deuxième matériau, le premier et le deuxième matériau présentant des coefficients de dilatation thermique différents, le procédé étant **caractérisé en ce qu'**il comporte :
a. la fourniture d'un substrat donneur (1) obtenu par collage d'une couche épaisse formée du premier matériau (la) et d'un substrat manipulateur (1b), la différence de coefficient de dilatation thermique du matériau constituant le substrat manipulateur (1b) et de celui du substrat support (7) étant moindre, en valeur absolue, que la différence de dilatation thermique de la couche épaisse (la) et de celui du substrat support (7), et le substrat donneur (1) présentant une face principale (4) du côté de la couche épaisse (la) ;
b. l'introduction d'espèces légères dans la couche épaisse (la) pour y générer un plan de fragilisation (2) et définir la couche mince (3) entre le plan de fragilisation (2) et la face principale (4) du substrat donneur (1);
c. l'assemblage de la face principale (4) du substrat donneur avec une face (6) du substrat support (7) ;
d. le détachement de la couche mince (3) au niveau du plan de fragilisation (2), le détachement comprenant l'application d'un traitement thermique.

2. Procédé selon la revendication précédente, dans lequel le coefficient de dilatation thermique du premier matériau constituant la couche épaisse (la) et celui du deuxième matériau constituant le substrat support (7) sont différents d'au moins 10% à température ambiante.

3. Procédé selon l'une des revendications précédentes, dans lequel les espèces légères implantées sont des ions d'hydrogène et/ou d'hélium.

4. Procédé selon l'une des revendications précédentes, dans lequel le premier matériau est un matériau ferroélectrique tel que du LiTaO3, LiNbO3, LiAlO3, BaTiO3, PbZrTiO3, KNbO3,BaZrO3, CaTiO3, PbTiO3 ou du KTaO3.

5. Procédé selon l'une des revendications précédentes, dans lequel le matériau du substrat support (7) est du silicium.

6. Procédé selon l'une des revendications précédentes, dans lequel le substrat manipulateur (1b) est de même nature que le substrat support (7).

7. Procédé selon l'une des revendications précédentes, dans lequel le substrat manipulateur (1b) possède une épaisseur équivalente à celle du substrat support (7).

8. Procédé selon l'une des revendications précédentes, dans lequel la couche épaisse (la) présente une épaisseur comprise entre 10 et 400 micromètres pour permettre le prélèvement d'une ou plusieurs couches minces.

9. Procédé selon l'une des revendications précédentes dans lequel le collage est obtenu par adhésion moléculaire.

10. Procédé selon l'une des revendications précédentes, comprenant une étape d'amincissement d'un substrat source (10) pour fournir la couche épaisse (la).

11. Procédé selon la revendication précédente dans lequel l'étape d'amincissement est réalisée par meulage et/ou polissage mécano-chimique et/ou gravure.

## Patentansprüche

1. Verfahren zum Übertragen einer Dünnschicht (3), die aus einem ersten Material besteht, auf ein Trägersubstrat (7), das aus einem zweiten Material besteht, wobei das erste und das zweite Material unterschiedliche Wärmeausdehnungskoeffizienten aufweisen, wobei das Verfahren **dadurch gekennzeichnet ist, dass** es Folgendes beinhaltet:
a. Bereitstellen eines Donorsubstrats (1), das durch Verbinden einer dicken Schicht, die aus dem ersten Material (1a) besteht, und eines Handhabungssubstrats (1b) erhalten wird, wobei der absolute Betrag der Differenz aus Wärmeausdehnungskoeffizienten des Materials, aus dem das Handhabungssubstrat (1b) besteht, und des Trägersubstrats (7) geringer als die Differenz aus der Wärmeausdehnung der dicken Schicht (1a) und des Trägersubstrats (7) ist und wobei das Donorsubstrat (1) auf der Seite der dicken Schicht (1a) eine Hauptfläche (4) aufweist;
b. Einbringen von leichten Spezies in die dicke Schicht (1a), um darin eine Abschwächungsebene (2) zu erzeugen und die Dünnschicht (3) zwischen der Abschwächungsebene (2) und der Hauptfläche (4) des Donorsubstrats zu definieren (1);
c. Zusammenfügen der Hauptfläche (4) des Donorsubstrats mit einer Fläche (6) des Trägersubstrats (7);
d. Ablösen der Dünnschicht (3) in Höhe der Abschwächungsebene (2), wobei das Ablösen das Anwenden einer Wärmebehandlung umfasst.

2. Verfahren nach dem vorhergehenden Anspruch, wobei sich der Wärmeausdehnungskoeffizient des ersten Materials, das die dicke Schicht (1a) bildet, und des zweiten Materials, das das Trägersubstrat (7) bildet, bei Umgebungstemperatur um mindestens 10 % unterscheiden.

3. Verfahren nach einem der vorhergehenden Ansprüche, wobei die implantierten leichten Spezies Wasserstoff- und/oder Heliumionen sind.

4. Verfahren nach einem der vorhergehenden Ansprüche, wobei das erste Material ein ferroelektrisches Material wie LiTaO₃, LiNbO₃, LiAlO₃, BaTiO₃, PbZrTiO₃, KNbO₃, BaZrO₃, CaTiO₃, PbTiO₃ oder KTaO₃ ist.

5. Verfahren nach einem der vorhergehenden Ansprüche, wobei das Material des Trägersubstrats (7) Silizium ist.

6. Verfahren nach einem der vorhergehenden Ansprüche, wobei das Handhabungssubstrat (1b) von gleicher Art wie das Trägersubstrat (7) ist.

7. Verfahren nach einem der vorhergehenden Ansprüche, bei dem das Handhabungssubstrat (1b) eine Dicke aufweist, die der des Trägersubstrats (7) entspricht.

8. Verfahren nach einem der vorhergehenden Ansprüche, wobei die dicke Schicht (1a) eine Dicke zwischen 10 und 400 Mikrometer aufweist, um das Abtragen einer oder mehrerer Dünnschichten zu ermöglichen.

9. Verfahren nach einem der vorhergehenden Ansprüche, bei dem das Verbinden durch molekulare Adhäsion erreicht wird.

10. Verfahren nach einem der vorhergehenden Ansprüche, umfassend einen Schritt des Dünnermachens eines Quellensubstrats (10), um die dicke Schicht (1a) bereitzustellen.

11. Verfahren nach dem vorhergehenden Anspruch, wobei der Schritt des Dünnermachens durch Schleifen und/oder mechanisch-chemisches Polieren und/oder Ätzen erfolgt.

## Claims

1. Method for transferring a thin film (3) made of a first material onto a support substrate (7) made of a second material, the first and the second material having different coefficients of thermal expansion, the method being **characterized in that** it comprises:
a. supplying a donor substrate (1) obtained by bonding a thick layer, formed of the first material (1a), and a handling substrate (1b), the difference in coefficient of thermal expansion of the material forming the handling substrate (1b) and that of the support substrate (7) being less, in absolute value, than the difference in thermal expansion of the thick layer (1a) and that of the support substrate (7), and the donor substrate (1) having a main face (4) on the thick layer (1a);
b. introducing light species into the thick layer (1a) to generate therein a plane of embrittlement (2) and to define the thin layer (3) between the plane of embrittlement (2) and the main face (4) of the donor substrate (1);
c. joining the main face (4) of the donor substrate with a face (6) of the support substrate (7);
d. detaching the thin layer (3) at the embrittlement plane (2), the detachment including application of a heat treatment.

2. Method according to the preceding claim, wherein the coefficient of thermal expansion of the first material forming the thick layer (1a) and that of the second material forming the support substrate (7) are different by at least 10% at room temperature.

3. Method according to either of the preceding claims, wherein the implanted light species are hydrogen ions and/or helium ions.

4. Method according to any of the preceding claims, wherein the first material is a ferroelectric material such as LiTaO3, LiNbO3, LiAlO₃, BaTiO₃, PbZrTiO₃, KNbO₃, BaZrO₃, CaTiO₃, PbTiO₃ or KTaO₃.

5. Method according to any of the preceding claims, wherein the material of the support substrate (7) is silicon.

6. Method according to any of the preceding claims, wherein the handling substrate (1b) is of the same kind as the support substrate (7).

7. Method according to any of the preceding claims, wherein the handling substrate (1b) has a thickness equivalent to that of the support substrate (7).

8. Method according to any of the preceding claims, wherein the thick layer (1a) has a thickness of between 10 and 400 micrometers to allow the removal of one or more thin layers.

9. Method according to any of the preceding claims, wherein the bonding is obtained by molecular adhesion.

10. Method according to any of the preceding claims, including a step of thinning a source substrate (10) to provide the thick layer (1a).

11. Method according to the preceding claim, wherein the thinning step is carried out by grinding and/or mechanical-chemical polishing and/or etching.
